# EUROPEAN PATENT SPECIFICATION

(11) **EP 0 614 136 B1**
(45) Date of publication and mention of the grant of the patent: **07.07.1999**
(21) Application number: 93103448.2
(22) Date of filing: 04.03.1993
(51) Int. Cl.: G05F 1/613, H03K 17/08, H03K 17/16

(54) **Power supply shunt regulator**
Shuntregler für eine Stromversorgung
Shunt régulateur pour source d'alimentation

(43) Date of publication of application: 07.09.1994
(73) Proprietor: ALCATEL, 75008 Paris (FR)
(72) Inventor: Delepaut, Christophe, B-1700 Dilbeek (BE)
(74) Representative: Narmon, Gisèle Marie Thérèse

(56) References cited:
- EP-A- 493 185
- DE-A- 3 335 520
- PROCEEDINGS OF THE THIRD ESTEC SPACECRAFT POWER CONDITIONING SEMINAR 21 September 1977, NOORDWIJK,NL pages 123 - 131 D. O'SULLIVAN ET AL. 'THE SEQUENTIAL SWITCHING SHUNT REGULATOR'

## Description

The present invention relates to a power supply shunt regulator as described in the preamble of claim 1.

Such a power supply shunt regulator is already known in the art, e.g. from the article "Design and development of a sequential switching shunt regulator", by I.R. White, Proc. of the 3d ESTEC Spacecraft Power Conditioning Seminar, Noordwijk (NL), 21-23 September 1977, pp. 133-136. This regulator is used to control the power supplied to the load by the power supply which consists of solar cells.

A problem with such a shunt regulator is that, when the shunt switch is turned on, the parasitic capacitor across the power supply discharges abruptly due to the short circuit which is so established. The current peak caused by this discharge may damage the shunt switch and thus reduces the system reliability. This is all the more worrying when the frequency with which the shunt switch is turned on and off is relatively high and when the regulator is used in spacecrafts which require very high reliability.

The known regulator therefore limits this discharge current via the current limitation means which includes in particular a capacitor C1 shown in Figure 7 of the referenced article. This capacitor artificially increases the Miller capacitance of the shunt switch, formed by T2 and T3, and thereby slows down the response of the regulator so limiting the current through the switch to a value which is dependent on the parasitic capacitance across the power supply and the power supplied by it.

Since the power supplied and the value of the parasitic capacitance are nonlinear and time- and temperature dependent, this known regulator has to limit the current to a value which is substantially lower than the maximum current dictated by a specific application by taking into account the above variations. In this way less current is available for the discharge of the parasitic capacitance leading to a slower discharge and consequently also to a larger power dissipation in the shunt switch. This larger dissipation diminishes the reliability of the regulator.

Moreover would the design of the regulator have to be redone for every application which is characterized by other parameters, for instance another parasitic capacitance. A further drawback of this known regulator is that the shunt switch is made with bipolar transistors which, due to their relatively high saturation voltage when turned on, dissipate relatively much energy thus complicating the design and increasing the dimensions of the regulator.

A shunt regulator of the above type but which limits the current to a value independent of the power supply characteristics and which dissipates less energy when the shunt switch is turned on is already known in the art, e.g. from the European Patent Application EP-A-O 493 185. Herein a similar power supply shunt regulator is described wherein the shunt switch is a field effect transistor and wherein the current limitation means comprises a negative feedback loop which is coupled between a current sensing resistor forming part of said series connection and said control electrode to regulate said analog control signal in such a way that the voltage drop across said current sensing resistor is lower than a maximum voltage drop and wherein the inductive means are coupled to the source electrode of said field effect transistor.

By providing a current limitation means in the form of an active feedback control loop of the above type, it can be easily verified that the current is limited to a value independent of the power supply characteristics. Indeed, the peak discharge current will clearly be limited to a fixed value dependent solely on the resistance of the current sensing resistor and the transfer function to the analog control signal realized by the limitation means.

The use of such an active feedback control loop in the present regulator is moreover non-trivial as explained hereafter.

Indeed, in order to improve the energy dissipation of the present regulator when the shunt switch is turned on, the shunt switch is configured as a Field Effect Transistor FET having a relatively low saturation voltage.

However, in spite of this major advantage, the use of a FET has the drawback that it has a relatively important drain-to-source parasitic capacitance value which gives rise to instability of the system from which the regulator forms a part. It can indeed be verified that the coupling between an inevitable inductance of the power supply lines, in the solar array field commonly known as harness inductance, and the parasitic capacitance across the terminals of the shunt switch is unstable. This instability overlies complicate the active feedback control loop.

An object of the present invention is to provide a shunt regulator of the above type but which has not the above drawback of giving rise to instability of the system.

This object is achieved due to the insight that this instability is taken away by providing a suitable degenerative inductive means, i.e. an inductor coupled between for instance the source of an n-FET shunt switch and the ground terminal, due to its limitation of the current variation in the branch by influencing the control voltage of the FET as explained below. Moreover, and due to this stabilization, can the transfer function of the current limitation means be of the optimal type as explained in detail below.

A characteristic feature of the present invention ensuring the mentioned stabilization is that the inductance of said inductive means is such that the poles of the following function are in the left half plane:$\text{H(s) =} \frac{\text{G}}{{\text{1 + G L}}_{\text{D}} {\text{s + PTC L}}_{\text{H}} {\text{s}}^{\text{2}}}$ wherein L_{D} is said inductance, G the voltage-to-current-gain of said shunt switch and PTC the parasitic drain-to-source capacitance of said field effect transistor, L_{H} the equivalent inductance of the power supply lines interconnecting said power supply with said branch and s the Laplacian variable. This is described in claim 1.

A further disadvantage of the known regulator leading to an unnecessary increase of the power dissipation is that the current through the shunt switch displays a significant current ripple. Indeed, due to this current ripple less current is effectively available to discharge the parasitic capacitor across the power supply than the maximum current allowed to flow through the switch would permit. This means, as already mentioned, that it takes longer to discharge the parasitic capacitance and that more energy is dissipated in the shunt switch then strictly needed.

A further characteristic feature of the present invention allowing to overcome this drawback is that said current limitation means includes an active negative feedback current controller deriving from a regulating input signal constituted by said voltage drop a regulating output signal (RO) on which said analog control signal is based and that the transfer function from said regulating input signal to said regulating output signal of said negative feedback current controller is determined in such a way that said voltage drop strives substantially critically damped to said maximum voltage drop.

In this way the above mentioned current ripple through the shunt switch is avoided. Indeed, with such a transfer function the current through the shunt switch 5 will strive to its maximal value in such a way that the difference between this maximum current and the steady state current is optimally used to discharge the parasitic capacitor across the power supply.

It is to be noted that this advantageous transfer function can be achieved in a simple way because the active negative feedback loop as described above is used and because of the stabilization achieved by way of the inductive means. Indeed, without the latter the operation of a controller with a same transfer function could not give rise to the desired response of the voltage drop.

Further characteristic features of the present invention are that said load and said current sensing resistor are connected to a ground terminal and that said current limitation means includes drive means for generating said analog control signal based on said regulating output signal, said drive means consisting of a drive branch including a series connection of amplifier means and short circuit means, being coupled between the floating terminals of said current sensing resistor and said load and generating said analog control signal as the voltage appearing on the junction point of said amplifier and short circuit means, said regulating output signal being the input signal to said amplifier means, and that said current controller further includes:
- a feedback branch including the series connection of a current feed means and a current drain means and coupled in parallel with said load, said regulating output signal being generated at the junction point of said current feed and current drain means,
- a polarization branch from which both said current feed and said current drain means are controlled and which is coupled in parallel with said drive branch,
and that an increase in said regulating input signal leads to an increase/decrease in the current flowing through said current drain/feed means, and that said current controller also includes a dynamic compensation branch coupled in parallel with said drive branch and including the series connection of resistive means and capacitive means coupled to said junction point of said feedback branch, and that said amplifier means includes a Darlington pair with associated load resistances which is coupled as a unity gain voltage amplifier, and that said short circuit means consists of the series connection of two transistors coupled in parallel and a degenerative resistor.

In the above way respectively a drive means and an active controller are provided using only little hardware whilst offering low design complexity and high reliability.

Indeed, the short circuit means included in the drive means ensures that the shunt switch is completely closed in the absence of an input signal to the amplifier means and in so doing it is avoided that the shunt switch is damaged by excessive dissipation due to continuous linear behaviour. Particularly, this short circuit means is such that the regulator is more robust with regard to threshold voltage lowering of the FET due to ageing and radiation and with regard to failures in the active controller, which is the reason for it being made redundant by providing two parallel transistors for it.

Furthermore is the active controller designed in a very simple way by providing two branches, i.e. feedback and polarization branch, performing the basic feedback operation using little hardware whilst the above mentioned desired transfer function of the active controller is determined by way of a separate third branch, i.e. the dynamic compensation branch. This branch, in providing a specific way out for the net current flowing from the junction point of the current feed and drain means, can be easily designed to yield the desired transfer function since it will determine the voltage on the latter junction point, this voltage being the regulating output signal, and hence the input to the Darlington pair which is in its turn coupled as a unity gain amplifier due to the short circuit means operating as a current source at FET turn on.

In more detail it can be seen that the design of the active controller is very simple since it solely consists in determining a proportional part of the desired transfer function through the resistive means and a dynamic part through the capacitive means.

Another characteristic of the present invention is that said capacitive means comprises 4 compensation capacitors coupled in two parallel branches each of which comprises the series connection of 2 of said compensation capacitors, said 4 compensation capacitors being equivalent to one capacitor having a capacitance value equal to the capacitance value of each of said compensation capacitors.

This characteristic allows to reduce dramatically the probability that one of two damaging failure modes of the compensation branch occurs.

The series redundancy avoids that the capacitive effect is lost due to a short circuit which would result in a constant linear operation of the shunt switch with corresponding overdissipation and probable loss of the shunt switch.

The parallel redundancy avoids that the response of the current controller degenerates to a non-optimal response due to the fact that the operation of the compensation branch is completely lost. Hence clearly the desired response of the voltage drop across the current sensing resistor can no longer be obtained resulting in a higher maximum current in the shunt switch due to current overshoot. The latter problem is particularly critical in high reliability applications where a redundant shunt switch, with corresponding duplicated regulator, is introduced in series with the first mentioned shunt switch. In that case, when the first mentioned shunt switch fails in short circuit the power supply is not lost due to the fact that the redundant shunt switch can take over. The above parallel redundancy of the compensation capacitors diminishes the probability that the regulator of the first mentioned shunt switch operates without adequate current limitation in such a way that both shunt switches are lost due to excessive current peaks. The parallel redundancy makes the capacitive means compatible with the series redundancy of the shunt switches.

Still another feature of the present invention is that said current controller is controlled by a binary control signal in such a way that said current controller is enabled/disabled dependent upon the actual value of said binary control signal, said control signal consisting of an open circuit/short circuit condition being applied to a first terminal of a control resistor whose second terminal is connected to said feedback branch on a point between said floating terminal of said load and said current feed means, and that said power supply is one of a plurality of similar solar array sections, said one section being able to be short circuited dependent on said binary control signal in order for the supply and demand of current to be matched in a spacecraft.

The above mentioned and other objects and features of the invention will become more apparent and the invention itself will be best understood by referring to the following description of an embodiment taken in conjunction with the accompanying drawings wherein :
Fig. 1 shows a schematic diagram of a power supply unit PSU in which a power supply shunt regulator PSSR according to the present invention is used,
Fig. 2 shows an equivalent electrical schematic of the power supply unit PSU and a shunt switch FET included in the regulator PSSR at turn on, and,
Fig. 3 represents a detailed electrical diagram of the regulator PSSR of Fig. 1.

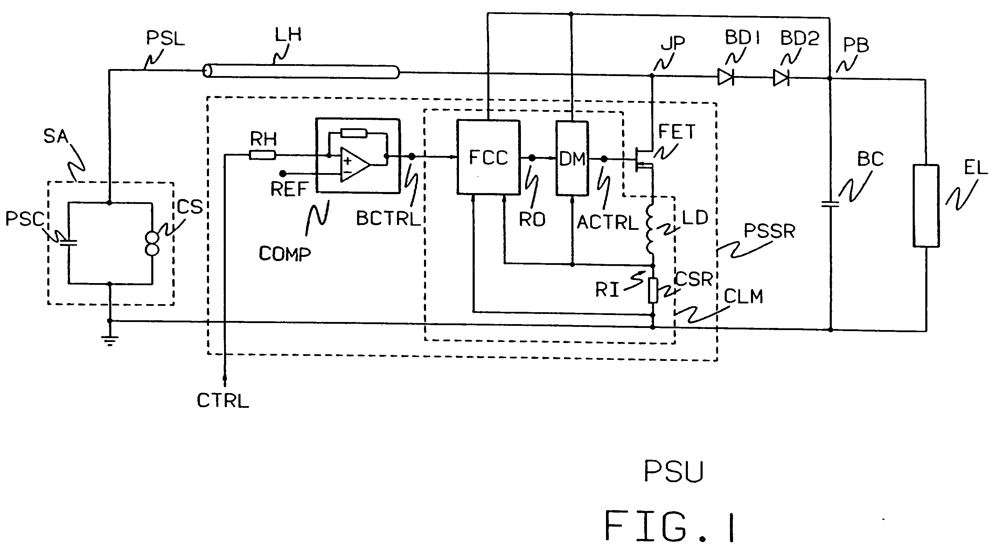

The power supply unit PSU shown in Fig. 1 can for instance be used in a spacecraft which electrical circuits constitute an electrical load EL which is powered by solar array sections such as the section SA. Since both the power supplied by SA as the power required by EL are fluctuating in time, means have to be provided to match the supply to the demand. As is well known in the art, e.g. from the article "Régulateur modulaire à grande puissance", Proc. of the 3d ESTEC Spacecraft power conditioning seminar, Noordwijk (NL), pp. 113-122, by A. Poncin et al. or from the article "The sequential switching shunt regulator S³R", ibid., by O'Sullivan et al., pp. 123-131, this can be done by selectively short circuiting a number of solar array sections such as SA so that only the power supplied by the remainder of the sections is gathered via a power bus PB and supplied to EL. This selective short circuiting can be done by a power supply shunt regulator PSSR which is controlled via a control input CTRL to either turn on/off a shunt switch embodied by a Field Effect Transistor FET so either avoiding/allowing the power of SA to be delivered to EL. The derivation of CTRL is known from the above articles and will therefore not be described here, in fact will it be assumed throughout the following that this derivation is performed by way of the S³R technique known from the last mentioned article. It is only to be noted that one of the solar array sections will be in a switching mode wherein it is continuously turned on and off in order to supply exactly the required amount of energy to the load EL and hence that the power supply shunt regulator has to be carefully designed due to this possible high switching strain.

In view of the above Fig. 1 will hereafter be described in detail.

The solar array section SA can be modelled as a current source CS in parallel with a parasitic section capacitor PSC and is connected between a symbolically represented ground terminal and a power supply line PSL having an equivalent so called "harness inductance" L_{H}. This power supply line PSL is in its turn connected to a junction point JP to which the like named terminal of a power bus PB is coupled via diodes BD1 and BD2. The power bus PB has an equivalent bus capacitance BC which stands in parallel to the electrical load EL and which is, as EL, connected between the terminal PB and the ground terminal.

It is to be noted that the integrating nature of BC is such that with one solar array section in switching mode it can be ensured that the power supplied to EL matches the sum of the amounts of power supplied by a number of solar array sections even when this sum is not exactly equal to the required power.

Finally the power supply shunt regulator PSSR is also connected between the junction point JP and the ground terminal and has the control input CTRL.

The power supply shunt regulator PSSR consists in more detail of a branch in parallel to the load EL and the solar array section SA and including between JP and the ground terminal the series connection of a shunt switch constituted by the above n-channel Field Effect Transistor FET, a degenerative inductor L_{D} and a current sensing resistor CSR. The shunt switch FET determines the impedance, short or open circuit, of the mentioned branch and is therefore controlled by an analog control signal ACTRL which is derived from the control signal CTRL by the circuits COMP, FCC and DM as described hereafter. The latter three circuits are connected to the terminal PB and thus receive a stable supply voltage from the power bus. It is to be noted that CTRL is coupled to COMP via a hysteresis resistor RH.

A symbolically represented comparator circuit COMP compares the signal provided by RH in response to the control signal CTRL with a reference signal REF, corresponding to the solar array section SA, and so derives the binary control signal BCTRL applied on a like named input terminal of an active negative feedback current controller FCC. The signal BCTRL has two states: a first one which is such that the current controller FCC sees on its input terminal BCTRL a short circuit and a second one which is such that FCC sees an open circuit. The active negative feedback current controller FCC, which is enabled/disabled by the binary output signal BCTRL of COMP further has a regulating input signal RI provided on a like named terminal and consituted by the voltage drop across the current sensing resistor CSR with respect to the ground terminal. FCC, when enabled, derives from RI a regulating output signal RO applied on a like named terminal connected to a drive means DM and constituted by the voltage on this terminal RO with respect to ground. DM is connected to the ground terminal via the current sensing resistor CSR, i.e. to RI. The drive means DM then finally derives the analog control signal ACTRL from the regulating output signal RO.

The above building blocks L_{D}, CSR, FCC and DM form a current limitation means CLM constituting an active negative feedback loop and forming together with the comparator means COMP and with the shunt switch FET the power supply shunt regulator PSSR. The operation of the power supply unit PSU will be further described in detail with reference to the following figures.

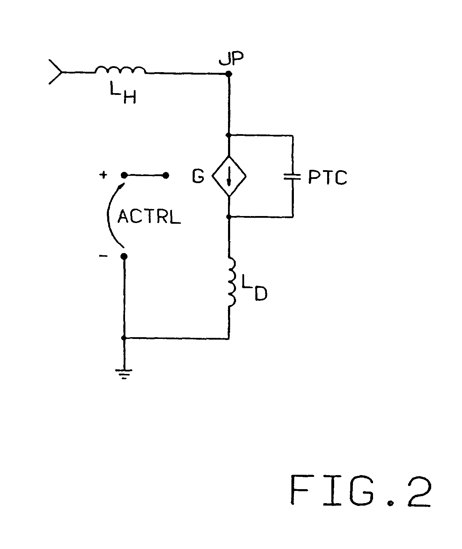

Fig. 2 shows an equivalent electrical schematic of the power supply unit PSU with the FET included in the regulator PSSR at turn on. This schematic includes the series connection of the harness inductor L_{H}, a simplified FET model consisting of a parallel connection of a voltage controlled current source G with controlling voltage ACTRL, and the parasitic transistor capacitor PTC, and the degenerative inductor L_{D}. The respective inductance, capacitance and gain values will hereafter be indicated with like named reference signs. It is to be noted that the other parasitic capacitors associated to the FET are neither shown in Fig. 2 nor considered in the following discussion since these capacitors were shown, both in simulation and in experiment, to have a negligible influence on the transfer function derived below.

It can now be simply verified that the transfer function H(s) from ACTRL to the current through the FET can be expressed in the Laplace domain as:$\text{H} \text{(} \text{s} \text{) =} \frac{\text{G}}{\text{1+} {\text{G L}}_{\text{D}} \text{s} \text{+} {\text{PTC L}}_{\text{H}} {\text{s}}^{\text{2}}}$

Setting L_{D} equal to zero in the above transfer function would clearly yield that the transfer function H(s) had poles on the imaginary axis and therefore that the corresponding electrical circuit were unstable due to the coupling between PTC and L_{H}. Such instability will be of major importance when, as in the present embodiment, the shunt switch is a FET which is commonly characterized by a relatively large value for the capacitance PTC.

It can then be clearly seen from the above formula that through an appropriate choice of the inductance value L_{H} the electrical circuit of Fig. 2, which corresponds to the power supply unit PSU at the moment the FET is turned on, can be made unconditionally stable. It is therefore also clear that the FET, due to its relatively large PTC, can be combined with the advantageous active negative feedback current controller FCC described below when the mentioned electrical circuit is made stable in the simple way described above. Indeed, the feedback control of an intrinsically unstable circuit would require a much more complex controller than described below.

The negative feedback current controller FCC in combination with the degenerative inductor L_{D} avoids these problems thanks to the fact that its transfer function can be chosen in such a way that it reliably determines a desired response at turn on for the current through the FET and that the maximum current to which the latter current will be limited only depends on the resistance value of CSR and on the transfer function of FCC.

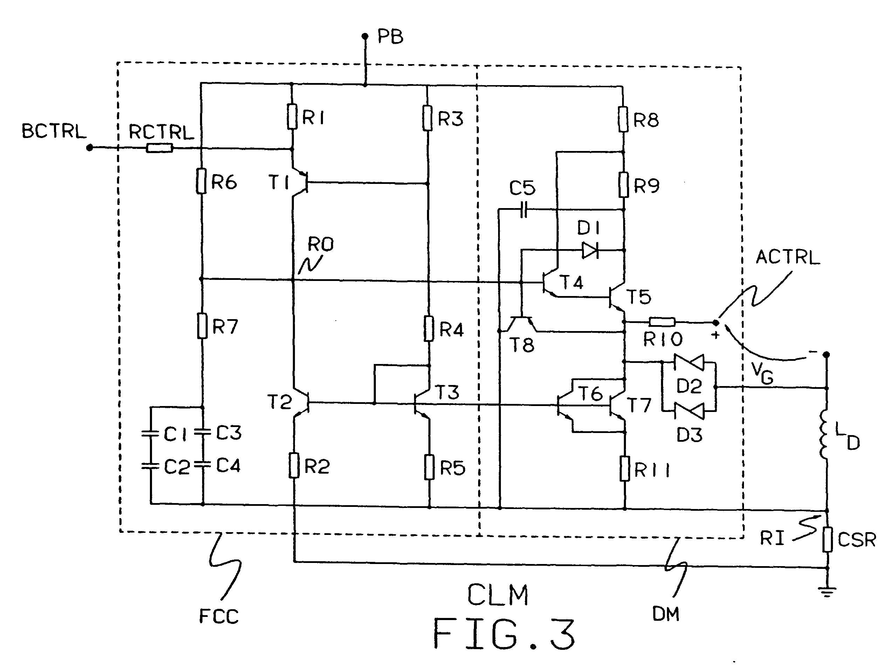

This negative feedback controller FCC and other parts of the current limitation means CLM will hereafter be described in detail with reference to Fig. 3. In this figure are more particularly represented those parts of CLM which derive the analog control signal ACTRL from both the binary control signal BCTRL and the regulating input signal RI, i.e. the voltage drop over CSR. These parts are fed from the terminal PB, on which the stable bus voltage is provided, and either the ground terminal or the floating terminal RI of CSR as will be described in detail below.

The feedback current controller FCC consists of three branches of which a feedback branch R1, T1, T2 and R2 is connected to the ground terminal and of which a polarization branch R3, R4, T3, and R5 and a dynamic compensation branch R6, R7 and C1/4 are connected to the floating terminal RI of CRS.

The feedback branch comprises the series connection of resistor R1, pnp-transistor T1, npn-transistor T2 and resistor R2 and receives the binary control signal BCTRL via a control resistor RCTRL, included to limit the reverse bias over T1 when BCTRL is in its short circuit state, on the junction point of R1 and T1.

The polarization branch comprises the series connection of the resistors R3, R4 and the npn-transistor T3 and finally the resistor R5. The base electrode of T1 is connected to the junction point of the resistors R3 and R4 whilst the base electrode of T2 is connected to both the base and the collector electrode of T3 as well as to the resistor R4.

The dynamic compensation branch comprises the series connection of the resistor R6, the resistive means R7 and the capacitive means C1-4 which is itself constituted by the parallel connection of two branches each including the series connection of two capacitors, C1/2 and C3/4, the capacitors C1-4 having equal capacitance values. The junction point of the resistors R6 and R7 is connected to the junction point of the transistors T1 and T2 and on this junction point RO the like named regulating output signal, constituted by the voltage on RO with respect to the ground, of FCC is provided.

The drive means R8-11, C5, T4-8 and D1 connected to the floating terminal RI of CSR comprises amplifier means including a Darlington pair formed with npn input and output transistors, T4 and T5 respectively. The base electrode of T4 is connected to the aforementioned terminal RO and its collector electrode is connected via resistor R8 to the power bus PB and via resistor R9 to the collector electrode of T5. The emitter electrode of T5 is in its turn connected to a short circuit means consisting of the series connection of npn-transistors T6/7 coupled in parallel and of a resistor R11. The emitter electrodes of T6/7 are connected to one end of resistor R11 whose other end is connected to the floating terminal RI of CRS. The emitter electrode of T5 is further connected via resistor R10 to a terminal ACTRL on which the like named analog control signal is provided. The drive means DM further includes a diode D1 connected between the base electrode of T4 and the collector electrode of T5 and a capacitor C5 coupled between the latter collector electrode and the collector electrode of pnp-transistor T8 whose base electrode is connected to the base electrode of T4 and whose emitter electrode is connected to the emitter electrode of T5. Finally the junction point of C5 and T8 is connected to the floating terminal of CRS and two Zener diodes D2/3 are coupled in parallel between the junction point of the inductor L_{D} and the shunt switch FET and the emitter electrode T5.

The operation of the feedback current controller FCC and the drive means as described above will now be discussed in detail.

As already mentioned, the binary control signal BCTRL can be considered as an enable/disable signal for the current controller FCC. Indeed in its high impedance state FCC sees on its terminal BCTRL an open circuit and a circuit via T1 in such a way that the current controller will be enabled since it is not influenced by BCTRL. If the signal BCTRL is such that FCC experiences a short circuit on its terminal BCTRL all current drawn from PB via R1 will be dumped through this short circuit and consequently T1 will be turned off, the regulating output signal on RO will then be shorted to the ground via T2, R2 and the amplifier means T4/5 will also be in an open circuit configuration. The analog control signal ACTRL will therefore be short circuited to the ground via the short circuit means T6/7, R11 in such a way that the FET is turned off. It can be clearly appreciated from the above that in the latter case the operation of FCC is disabled and that consequently the FET is closed.

The operation of FCC will now be described from the moment BCTRL enables FCC onwards.

It is however first to be noted that the Darlington pair is coupled as a unity gain voltage amplifier from the regulating output signal RO to the voltage at the emitter electrode of T5 which is achieved by the inclusion of R11 in the short circuit means. Indeed from the moment current starts to flow through the branch R8/9, T5/7, R11, the short circuit means will operate as a current source for the whole duration in which the controller FCC is enabled. Therefore also it is clear that a negligible amount of current will flow from RO to the Darlington pair due to the infinite gain of the Darlington pair coupled in this way. The above has the advantage that the exact response of the Darligton pair need not be known.

In view of the above the operation of FCC can be understood as follows; when FCC is enabled the current can no longer leave FCC via BCTRL and will hence start to flow through T1 which is turned on. T1 can in this respect be seen as a current feed towards terminal RO and is rivalled by a current drain constituted by T2 drawing current away from the latter terminal RO. At turn on beginning the resulting effect is a current which flows, due to the above described Darlington configuration, through the compensation branch and causes the voltage RO at the like named regulating output to rise. The unity gain Darlington copies this voltage to the emitter electrode of T5 in such a way that the control voltage ACTRL on the gate electrode of the FET will also gradually increase and that the FET is turned on allows current to flow through the branch in which it is included.

Evidently this turn on results in an increase of the current through the shunt switch FET and hence an increase in the voltage drop RI across CSR. This rate of increase is limited by the inductor L_{D} and by the fact that the latter inductor has a local feedback effect on the FET due to the source voltage increase resulting from the changing current through the inductor which thus stabilizes the circuit as described above. But this increase in the voltage drop or regulating input signal RI will also have an effect via the current controller FCC. Indeed, due to this increase the voltages on the junction points of the polarization branch will also increase which verifiably leads to an increase in both the base voltage of the current feed T1 and the current drain T2. These increases respectively increase/decrease the current flowing to/from RO so that the current flowing through the compensation branch is reduced. Hence also, the regulating output signal or voltage on RO will decrease which evidently results in a decrease of the voltage ACTRL.

From the above it can be clearly verified that the feedback and polarization branch together with the drive means achieve a negative feedback current control of the current flowing through the FET. This current control would in the absence of the compensation branch be too strong since then the infinite gain of the present Darlington pair would drive the FET almost instantaneously back to cut-off in such a way that in spite of the inclusion of L_{D} the large open loop gain corresponding to the feedback loop CLM will lead to current overshoot and current ripple when the FET is turned on. These overshoot and ripple effects are less severe but also undesirable for the same reasons as mentioned above with regards to unstable operation.

Therefore the present regulator PSSR requires the inclusion of the compensation branch in order to optimize the transfer function of FCC from RI to RO in view of an optimal turn on behaviour, i.e. in such a way that the current through the FET increases in a critically damped way to the maximum current, i.e. with least delay and without overshoot. This desired transfer function can then be achieved in a very simply way once the dynamic compensation branch is introduced. Indeed, this branch will almost completely determine the transfer function of FCC due to the fact that the amplifier means is a unity gain amplifier. In the present case a desired transfer function can be achieved through inclusion in the compensation branch of resistive means R7 giving a proportional response and through inclusion of capacitive means C1-4 giving an integrating response.

From the above qualitative discussion, it can be seen that the compensation capacitors C1-4 determine the dynamic behaviour of the current controller FCC and in combination with L_{D} the dynamic behaviour of CLM. As explained above, the transfer function of the current controller FCC can, thanks to the stabilization performed by the inductor L_{D}, be so chosen that the voltage drop RI rises to a maximum voltage drop in a critically damped way. It is to be noted that the latter response is in particular obtained with the parameters for the PSSR listed in table 1 below.

It is to be noted that a number of redundant elements are included in the controller FCC in order to make a number of damaging failure modes unlikely. Firstly, there is the parallel and series redundancy of the capacitors C1-4 to avoid the short circuit or open circuit failure modes of the capacitive means which is advantageous since these failure modes are very undesirable as explained higher. The inclusion of resistor R6 (with very high resistance, see table 1) further avoids that, in case of an open circuit failure of T2, terminal RO is in a high impedance state which might result in constant linear operation of the FET and corresponding damage to this FET. Finally the Zener diodes D2/3 are included to avoid damage to the FET resulting from gate-to-source voltages exceeding 10V and to avoid too negative gate-to source voltages when the FET is turned off. Indeed, such excessive negative voltages are equally damaging to the FET and are clearly avoided through the inclusion of D2/3.

Finally, the turn off response of the power supply shunt regulator PSSR will be briefly described.

Also in turn off the delay in reaching the steady state has to be diminished. Indeed, any delay, either in turning on or off the FET results in some voltage ripple on the power bus PB which is a well known side-effect in the S³R technique. When these delays become excessive this voltage ripple may become such that two solar array sections are put by their control signals in switching mode as described above. This is very undesirable and therefore these delays are diminished in the way described below. Further requirements are that the switching does not cause too large current changes which might lead to electro-magnetic interference and that the turn off is complete, i.e. that the FET is not controlled via ACTRL to operate constantly in linear mode dissipating excessive amounts of energy. The latter would be in conflict with the series redundancy of a redundant shunt switch as already higher. Indeed through such a linear failure both shunt switches could be simultaneously damaged through excessive dissipation making the redundancy useless.

The above requirements are met by the present shunt regulator PSSR as briefly discussed hereafter.

In turning off it is avoided by the inductor L_{D} that this turning off would be too blunt resulting in the mentioned electro-magnetic interference. Indeed the local feedback effect of this inductor avoids such a blunt switching due to the fact that a decrease in current through L_{D} causes the voltage on the source electrode of the FET to decrease below the voltage on the ground terminal thus opening the FET a little bit in response. This smoothing out of the current variation through the FET is desired since otherwise the current from the solar array SA, prohibited to vary rapidly by the harness inductance L_{H}, could no longer flow through the FET which in its turn would lead to a large voltage peak on its drain electrode. The latter would be damaging for the FET due to a large transient response and would yield interference due to the current and voltage peaks induced by such switching.

It is further needed to suit the above requirements that the analog control signal ACTRL on the gate electrode of the FET is rapidly and securely brought to the voltage on the ground terminal so that it is ensured that, when in steady state, the FET is totally off without unnecessary power dissipation. This is achieved rapidly due to the fact that diode D1 avoids that a large saturation voltage is present over the transistors T4/5 of the Darlington pair and due to transistor T8 which is perfectly coupled to short terminal ACTRL to the ground since it contributes, thanks to its coupling, to the discharge of the parasitic capacitors of the FET. This is achieved securely by the redundant short circuit means T6/7 which have an extremely low collector-emitter voltage drop of 0.1V when not conducting any current. Due to their redundancy it is moreover made highly unprobable that this short circuit will be lost which would have as a consequence the linear operation of the FET at turn off. For this reason the FET is also of the "hardened" type, i.e. its threshold voltage diminishes only slightly under influence of radiation or ageing so that its linear operation during turn off is highly unlikely. Finally is the dissipation improved via the choice of the Darlington pair, not needing an elaborate polarization circuit.

**table 1:**

| *values and types of elements in Fig. 3* | |
|---|---|
| **RESISTORS (Ω)** | |
| RCTRL | 16K |
| R1 | 12.66K |
| R2 | 363.3 |
| R3 | 12.97K |
| R4 | 18.51K |
| R5 | 150 |
| R6 | 1.8M |
| R7 | 10K |
| R8 | 1.9K |
| R9 | 100 |
| R10 | 20 |
| R11 | 18 |
| CSR | 20m |

| **TRANSISTORS (type)** | |
|---|---|
| T1 | 2N2907A |
| T2/3 | 2N2920 |
| T4/5 | 2N3700 |
| T6/7 | 2N2920 |
| T8 | 2N2907A |
| FET | IRF150 |

| **CAPACITORS (F)** | |
|---|---|
| C1-4 | 330p |
| C5 | 1n |

| **INDUCTOR (H)** | |
|---|---|
| L_{D} | 400n |

| **DIODES (type)** | |
|---|---|
| D1 | 1N5806 |
| D2/3 | 1N4104 |

## Claims

1. Power supply shunt regulator (PSSR) including a branch (FET, L_{D}, CSR) which includes the series connection of at least a shunt switch (FET) and an inductive means (L_{D}) and which is coupled in parallel with both a load (EL) and a power supply (SA), said regulator including current limitation means (CLM) for generating an analog control signal (ACTRL) applied to a control electrode of said shunt switch so as to limit the amount of current flowing through said shunt switch being a field effect transistor (FET), said current limitation means (CLM) comprising a negative feedback loop (FCC, DM, FET L_{D}, CSR) coupled between a current sensing resistor (CSR) which forms part of said series connection (FET, L_{D}, CSR) and said control electrode to regulate said analog control signal (ACTRL) in such a way that the voltage drop (RI) across said current sensing resistor is lower than a maximum voltage drop, said inductive means (L_{D}) being coupled to the source electrode of said field effect transistor, characterized in that the inductance of said inductive means (L_{D}) is such that the poles of the following function are in the left half plane:$\text{H(s)=} \frac{\text{G}}{{\text{1+G L}}_{\text{D}} {\text{s+PTC L}}_{\text{H}} {\text{s}}^{\text{2}}}$ wherein L_{D} is said inductance, G the voltage-to-current-gain of said shunt switch and PTC the parasitic drain-to-source capacitance (PTC) of said field effect transistor (FET), L_{H} the equivalent inductance of the power supply lines (PSL) interconnecting said power supply (SA) with said branch (FET, L_{D}, CSR) and s the Laplacian variable.

2. Power supply shunt regulator (PSSR) according to claim 1, characterized in that said current limitation means includes an active negative feedback current controller deriving from a regulating input signal constituted by said voltage drop (RI) a regulating output signal (RO) on which said analog control signal (ACTRL) is based and that the transfer function from said regulating input signal (RI) to said regulating output signal (RO) of said negative feedback current controller (FCC) is determined in such a way that said voltage drop (RI) strives substantially critically damped to said maximum voltage drop.

3. Power supply shunt regulator (PSSR) according to any of the previous claims, characterized in that said load (EL) and said current sensing resistor (CSR) are connected to a ground terminal and that said current limitation means (CLM) includes drive means (DM) for generating said analog control signal (ACTRL) based on said regulating output signal, said drive means consisting of a drive branch (R8/9, T4/5, T6/7, R11) including a series connection of amplifier means (R8/9, T4/5) and short circuit means (R11, T6/7), being coupled between the floating terminals of said current sensing resistor (CSR) and said load (EL) and generating said analog control signal (ACTRL) as the voltage appearing on the junction point of said amplifier and short circuit means, said regulating output signal (RO) being the input signal to said amplifier means.

4. Power supply shunt regulator (PSSR) according to claim 3, characterized in that said current controller (FCC) further includes:
- a feedback branch (R1, T1, T2, R2) including the series connection of a current feed means (T1) and a current drain means (T2) and coupled in parallel with said load (EL), said regulating output signal (RO) being generated at the junction point of said current feed and current drain means,
- a polarization branch (R3, R4, T3, R5) from which both said current feed and said current drain means are controlled and which is coupled in parallel with said drive branch (R8/9, T4/5, T6/7, R11),
and that an increase in said regulating input signal (RI) leads to an increase/decrease in the current flowing through said current drain/feed means.

5. Power supply shunt regulator (PSSR) according to claims 2 and 4, characterized in that said current controller (FCC) also includes a dynamic compensation branch (R6, R7, C1-4) coupled in parallel with said drive branch (R8/9, T4/5, T6/7, R11) and including the series connection of resistive means (R7) and capacitive means (C1-4) coupled to said junction point (RO) of said feedback branch, and that said amplifier means (R8/9, T4/5) includes a Darlington pair (T4/5) with associated load resistances (R8/9) which is coupled as a unity gain voltage amplifier, and that said short circuit means (R11, T6/7) consists of the series connection of two transistors coupled in parallel and a degenerative resistor (R11).

6. Power supply shunt regulator according to claim 5, characterized in that said capacitive means (C1-4) comprises 4 compensation capacitors (C1-4) coupled in two parallel branches each of which comprises the series connection of 2 of said compensation capacitors, said 4 compensation capacitors being equivalent to one capacitor having a capacitance value equal to the capacitance value of each of said compensation capacitors.

7. Power supply shunt regulator according claim 5, characterized in that a diode (D1) is connected between the base electrode of the input transistor (T4) of said pair and the collector electrode of the output transistor (T5) of said pair, and that a further short circuit means (T8) is provided and consists of a transistor(T8) whose base electrode is connected to the base electrode of said input transistor and whose emitter electrode is coupled to the emitter electrode of said output transistor and whose collector electrode is connected to said floating terminal of said current sensing resistor (CRS).

8. Power supply shunt regulator (PSSR) according to any of the claims 3 to 7, characterized in that said current controller (FCC) is controlled by a binary control signal (BCTRL) in such a way that said current controller is enabled/disabled dependent upon the actual value of said binary control signal (BCTRL), said control signal consisting of an open circuit/short circuit condition being applied to a first terminal (BCTRL) of a control resistor (RCTRL) whose second terminal is connected to said feedback branch (R1, T1, T2, R2) on a point between said floating terminal of said load (EL) and said current feed means (T1).

9. Power supply shunt regulator (PSSR) according to claim 8, characterized in that said power supply (SA) is one of a plurality of similar solar array sections, said one section being able to be short circuited dependent on said binary control signal (BCTRL) in order for the supply and demand of current to be matched in a spacecraft.

## Patentansprüche

1. Nebenschlußregler für eine Stromversorgung (PSSR) umfassend einen Zweig (FET, L_{D}, CSR) der eine Reihenschaltung mit wenigstens einem Nebenschlußschalter (FET) und eine induktive Einrichtung (L_{D}) aufweist und der sowohl zu einem Verbraucher (EL) als auch zu einer Stromversorgung (SA) parallel geschaltet ist, wobei der Regler umfaßt eine Strombegrenzungseinrichtung (CLM) zum Erzeugen eines analogen Steuersignals (ACTRL), das an eine Steuerelektrode des Nebenschlußschalters angelegt wird, um so den Betrag des Stromes, der durch den als Feldeffekttransistor (FET) ausgebildeten Nebenschlußschalter fließt, zu begrenzen, wobei die Strombegrenzungseinrichtung (CLM) eine negative Rückkopplungsschleife (FCC, DM, FET, L_{D}, CSR) umfaßt, die zwischen einen stromdetektierenden Widerstand (CSR), der ein Teil der Reihenschaltung (FET, L_{D}, CSR) ist, und der Steuerelektrode zum Regeln des analogen Steuersignals (ACTRL) in einer Art und Weise, daß der Spannungsabfall (RI) am stromdetektierenden Widerstand geringer als ein maximaler Spannungsabfall ist, gekoppelt ist, wobei die induktive Einrichtung (L_{D}) an die Source-Elektrode des Feldeffekttransistors angeschlossen ist, dadurch gekennzeichnet, daß die Induktivität der induktiven Einrichtung (L_{D}) so ist, daß die Pole der folgenden Funktion in der linken Halbebene liegen:$\text{H(s)=} \frac{\text{G}}{{\text{1+G L}}_{\text{D}} {\text{s +PTC L}}_{\text{H}} {\text{s}}^{\text{2}}}$ wobei L_{D} die Induktivität ist, G die Spannung-zu-Strom-Verstärkung des Nebenschlußschalters und PTC die parasitäre Drain-zu-Source-Kapazität (PTC) des Feldeffekttransistors (FET) ist, L_{H} die äquivalente Induktivität der Leistungszuführleitung (PSL) ist, die die Stromversorgung (SA) mit dem Zweig (FET, L_{D}, CSR) verbindet und s die Laplace-Variable ist.

2. Nebenschlußregler für eine Stromversorgung (PSSR) gemäß Anspruch 1, dadurch gekennzeichnet, daß die Strombegrenzungseinrichtung eine aktive negative Rückkopplungsstromsteuereinrichtung aufweist, die von einem regelnden Eingabesignal, das durch den Spannungsabfall (RI) dargestellt wird, ein regelndes Ausgabesignal (RO) ableitet, auf dem das analoge Steuersignal (ACTRL) beruht und das die Übertragungsfunktion von dem regelnden Eingabesignal (RI) zu dem regelnden Ausgabesignal (RO) der negativen Rückkopplungsstromsteuereinrichtung (FCC) in einer Art und Weise bestimmt wird, daß der Spannungsabfall (RI) auf den maximalen Spannungsabfall bestrebt im wesentlichen kritisch gedämpft ist.

3. Nebenschlußregler für eine Stromversorgung (PSSR) nach einem der vorhergehenden Ansprüche, dadurch gekennzeichnet, daß der Verbraucher (EL) und der den Strom detektierende Widerstand (CSR) mit einem Masseanschluß verbunden sind und daß die Strombegrenzungseinrichtung (CLM) eine Treibereinrichtung (DM) zum Erzeugen des analogen Steuersignals (ACTRL), das auf dem regelnden Ausgabesignal beruht, aufweist, wobei die Treibereinrichtung aus einem Treiberzweig (R8/9, T4/5, T6/7, R11) besteht, der eine Reihenschaltung aus einer Verstärkereinrichtung (R8/9, T4/5) und einer Kurzschlußschaltereinrichtung (R11, T6/7) umfaßt, die zwischen den ungeerdeten Anschlüssen des den stromdetektierenden Widerstandes (CSR) und des Verbrauchers (EL) geschaltet sind und das analoge Steuersignal (ACTRL) erzeugen, wenn an dem Verbindungspunkt des Verstärkers und der Kurzschlußschaltungseinrichtung die Spannung auftritt, wobei das regelnde Ausgabesignal (RO) das Eingabesignal der Verstärkereinrichtung ist.

4. Nebenschlußregler für eine Stromversorgung (PSSR) gemäß Anspruch 3, dadurch gekennzeichnet, daß die Stromsteuereinrichtung (FCC) ferner umfaßt:
- einen Rückkopplungszweig (R1, T1, T2, R2) umfassend eine Reihenschaltung mit einer Stromzuführungseinrichtung (T1) und einer Stromsenkeneinrichtung (T2) und die parallel zu dem Verbraucher (EL) geschaltet ist, wobei das regelnde Ausgabesignal (RO) am Verbindungspunkt der Stromzuführung und der Stromsenkeneinrichtung erzeugt wird,
- einen Polarisationszweig (R3, R4, T3, R5) von dem sowohl die Stromzuführung als auch die Stromsenkeneinrichtung gesteuert werden und der parallel zu dem Treiberzweig (R8/9, T4/5, T6/7, R11) geschaltet ist,
und daß eine Zunahme des regelnden Eingangssignals (RI) zu einer Zunahme/Abnahme des Stromflußes durch die Stromsenke-/Zuführeinrichtung führt.

5. Nebenschlußregler für eine Stromversorgung (PSSR) gemäß den Ansprüchen 2 und 4, dadurch gekennzeichnet, daß die Stromreglereinrichtung (FCC) auch einen dynamischen Kompensationszweig (R6, R7, C1 bis 4) umfaßt, der parallel zu dem Treiber (R8/9, T4/5, T6/7, R11) geschaltet ist und eine Reihenschaltung aus einer Widerstandseinrichtung (R7) und einer kapazitiven Einrichtung (C1 bis 4) aufweist, die an den Verbindungspunkt (RO) des Rückkopplungszweiges angeschlossen ist, und daß die Verstärkereinrichtung (R8/9, T4/5) ein Darlington-Paar (T4/5) mit den damit verbundenen Lastwiderständen (R8/9) aufweist, das als Spannungsfolger geschaltet ist, und daß die Kurzschlußschaltungseinrichtung (R11, T6/7) aus einer Reihenschaltung aus zwei parallel geschalteten Transistoren und einem Rückkoppelwiderstand (R11) besteht.

6. Nebenschlußregler für eine Stromversorgung nach Anspruch 5, dadurch gekennzeichnet, daß die kapazitive Einrichtung (C1 bis 4) vier Kompensationskondensatoren (C1 bis 4) umfaßt, die in zwei parallele Zweige von welchen jeder die Reihenschaltung von zwei Kompensationskondensatoren aufweist geschaltet sind, wobei die vier Kompensationskondensatoren äquivalent zu einem Kondensator mit einem Kapazitätswert sind, der mit dem Kapazitätswert eines jeden der Kompensationskondensatoren übereinstimmt.

7. Nebenschlußregler für eine Stromversorgung nach Anspruch 5, dadurch gekennzeichnet, daß eine Diode (D1) zwischen der Basiselektrode des Eingangstransistors (T4) des Paares und der Kollektorelektrode des Ausgangstransistors (T5) des Paares geschaltet ist, und daß ferner eine Kurzschlußschaltungseinrichtung (T8) vorgesehen ist, die aus einem Transistor (T8) besteht, dessen Basiselektrode mit der Basiselektrode des Eingangstransistors verbunden ist und dessen Emitterelektrode mit der Emitterelektrode des Ausgangstransistors verbunden ist und dessen Kollektorelektrode mit dem ungeerdeten Anschluß des den Strom abtastenden Widerstandes (CRS) verbunden ist.

8. Nebenschlußregler für eine Stromversorgung (PSSR) nach einem der Ansprüche 3 bis 7, dadurch gekennzeichnet, daß die Stromsteuereinrichtung (FCC) durch ein binäres Steuersignal (BCTRL) in einer Art und Weise gesteuert wird, daß die Stromsteuereinrichtung in Abhängigkeit vom tatsächlichen Wert des binären Steuersignals (BCTRL) aktiviert/deaktiviert ist, wobei das Steuersignal, das aus einem Zustand für eine Unterbrechung bzw. Kurzschluß besteht, an einen ersten Anschluß (BCTRL) eines Steuerwiderstandes (RCTRL) angelegt wird, dessen zweiter Anschluß mit dem Rückkopplungszweig (R1, T1, T2, R2) an einem Punkt zwischen dem ungeerdeten Anschluß des Verbrauchers (EL) und der Stromzuführungseinrichtung (T1) verbunden ist.

9. Nebenschlußregler für eine Stromversorgung (PSSR) nach Anspruch 8, dadurch gekennzeichnet, daß die Stromversorgung (SA) eine von mehreren ähnlichen Solarzellenabschnitten ist, wobei ein Abschnitt in Abhängigkeit von dem binären Steuersignal (BCTRL) kurzgeschlossen werden kann, um die Versorgung und den Bedarf an Strom in einem Raumfahrzeug in Übereinstimmung zu bringen.

## Revendications

1. Régulateur shunt d'alimentation (PSSR) comportant une branche (FET, L_{D}, CSR) qui comporte la connexion en série d'au moins un commutateur de shunt (FET) et de moyens inductifs (L_{D}) et qui est couplé en parallèle à la fois à une charge (EL) et à une alimentation (SA), ledit régulateur comportant des moyens de limitation de courant (CLM) destinés à générer un signal de contrôle analogique (ACTRL) appliqué à une électrode de contrôle dudit commutateur de shunt de façon à limiter la quantité de courant s'écoulant à travers ledit commutateur de shunt, qui est un transistor à effet de champ (FET), lesdits moyens de limitation de courant (CLM) comprenant une boucle de réinjection négative (FCC, DM, FET, L_{D}, CSR) couplée entre une résistance de détection de courant (CSR) faisant partie de ladite connexion en série (FET, L_{D}, CSR) et ladite électrode de contrôle pour réguler ledit signal de contrôle analogique (ACTRL) d'une façon telle que la chute de tension (RI) aux bornes de ladite résistance de détection de courant soit inférieure à une chute de tension maximale, lesdits moyens inductifs (L_{D}) étant couplés à l'électrode de source dudit transistor à effet de champ, caractérisé en ce que l'inductance desdits moyens inductifs (L_{D}) est telle que les pôles de la fonction suivante se trouve dans le demi-plan de gauche :$\text{H(s) =} \frac{\text{G}}{{\text{1+G L}}_{\text{D}} {\text{s+PTC L}}_{\text{H}} {\text{s}}^{\text{2}}}$ où L_{D} est ladite inductance, G est le gain tension-courant dudit commutateur de shunt et PTC est la capacité parasite drain-source (PTC) dudit transistor à effet de champ (FET), L_{H} a est l'inductance équivalente des lignes d'alimentation (PSL) interconnectant ladite alimentation (SA) à ladite branche (FET, L_{D}, CSR) et s est la variable de Laplace.

2. Régulateur shunt d'alimentation (PSSR) selon la revendication 1, caractérisé en ce que lesdits moyens de limitation de courant comportent un contrôleur de courant de réinjection négative active déterminant d'après un signal d'entrée de régulation constitué par ladite chute de tension (RI), un signal de sortie de régulation (RO), sur lequel est basé ledit signal de contrôle analogique (ACTRL) et que la fonction de transfert entre ledit signal d'entrée de régulation (RI) et ledit signal de sortie de régulation (RO) dudit contrôleur de courant de réinjection négative (FCC) est déterminé d'une façon telle que ladite chute de tension (RI) s'efforce de façon sensiblement critique d'être amortie à ladite chute de tension maximale.

3. Régulateur shunt d'alimentation (PSSR) selon l'une quelconque des revendications précédentes, caractérisé en ce que ladite charge (EL) et ladite résistance de détection de courant (CSR) sont connectées à une borne de masse et que lesdits moyens de limitation de courant (CLM) comportent des moyens de commande (DM) pour générer ledit signal de contrôle analogique (ACTRL) sur la base dudit signal de sortie de régulation, lesdits moyens de commande étant constitués d'une branche de commande (R8/9, T4/5, T6/7, R11) comportant une connexion en série de moyens amplificateurs (R8/9, T4/5) et de moyens de court-circuit (R11, T6/7), couplés entre les bornes flottantes de ladite résistance de détection de courant (CSR) et ladite charge (EL) et générant ledit signal de contrôle analogique (ACTRL) comme étant la tension apparaissant au point de jonction dudit amplificateur et des moyens de court-circuit, ledit signal de sortie de régulation (RO) étant le signal d'entrée vers lesdits moyens amplificateurs.

4. Régulateur shunt d'alimentation (PSSR) selon la revendication 3, caractérisé en ce que ledit contrôleur de courant (FCC) comporte en outre :
- une branche de réinjection (R1, T1, R2, T2) comportant la connexion en série de moyens d'alimentation de courant (T1) et de moyens de drain de courant (T2) et couplée en parallèle avec ladite charge (EL), ledit signal de sortie de régulation (RO) étant généré au point de jonction desdits moyens d'alimentation de courant et de drain de courant,
- une branche de polarisation (R3, R4, T3, R5) à partir de laquelle sont contrôlés, à la fois lesdits moyens d'alimentation de courant et de drain de courant, et qui est couplée en parallèle avec ladite branche de commande (R8/9, T4/5, T6/7, R11),
et qu'une augmentation dudit signal d'entrée de régulation (RI) conduit à une augmentation/diminution du courant s'écoulant à travers lesdits moyens de drain/alimentation de courant.

5. Régulateur shunt d'alimentation (PSSR) selon les revendications 2 et 4, caractérisé en ce que ledit contrôleur de courant (FCC) comporte également une branche de compensation dynamique (R6, R7, C1-4) couplée en parallèle avec ladite branche de commande (R8/9, T4/5, T6/7, R11) et comportant la connexion en série de moyens résistifs (R7) et de moyens capacitifs (C1-4) couplés audit point de jonction (RO) de ladite branche de réinjection et que lesdits moyens amplificateurs (R8/9, T4/5) comportent une paire Darlington (T4/5) avec des résistances de charge associées (R8/9), couplée sous la forme d'un amplificateur de tension de gain unitaire et que lesdits moyens de court-circuit (R11, T6/7) sont constitués de la connexion en série de deux transistors couplés en parallèle et d'une résistance de dégénérescence (R11).

6. Régulateur shunt d'alimentation selon la revendication 5, caractérisé en ce que lesdits moyens capacitifs (C1-4) comprennent 4 condensateurs de compensation (C1-4) couplés dans deux branches parallèles, chacune d'entre elles comprenant la connexion en série de 2 desdits condensateurs de compensation, lesdits 4 condensateurs de compensation étant équivalents à un condensateur ayant une valeur de capacité égale à la valeur de capacité de chacun desdits condensateurs de compensation.

7. Régulateur shunt d'alimentation selon la revendication 5, caractérisé en ce qu'une diode (D1) est connectée entre l'électrode de base du transistor d'entrée (T4) de ladite paire et l'électrode de collecteur du transistor de sortie (T5) de ladite paire et que d'autres moyens de court-circuit (T8) sont prévus et sont constitués d'un transistor (T8) dont l'électrode de base est connectée à l'électrode de base dudit transistor d'entrée et dont l'électrode d'émetteur est couplée à l'électrode d'émetteur dudit transistor de sortie et dont l'électrode de collecteur est connectée à ladite borne flottante de ladite résistance de détection de courant (CRS).

8. Régulateur shunt d'alimentation (PSSR) selon l'une quelconque des revendications 3 à 7, caractérisé en ce que ledit contrôleur de courant (FCC) est contrôlé par un signal de contrôle binaire (BCTRL) d'une manière telle que ledit contrôleur de courant est activé/désactivé en fonction de la valeur réelle dudit signal de contrôle binaire (BCTRL), ledit signal de contrôle étant constitué d'une condition de circuit ouvert/court-circuit appliquée à une première borne (BCTRL) d'une résistance de contrôle (RCTRL) dont la deuxième borne est connectée à ladite branche de réinjection (R1, T1, T2, R2) en un point situé entre ladite borne flottante de ladite charge (EL) et lesdits moyens d'alimentation de courant (T1).

9. Régulateur shunt d'alimentation (PSSR) selon la revendication 8, caractérisé en ce que ladite alimentation (SA) est une section parmi une pluralité de sections de panneaux solaires similaires, ladite section étant capable d'être court-circuitée en fonction dudit signal de contrôle binaire (BCTRL) pour que l'alimentation et la demande de courant correspondent dans un véhicule spatial.
